Europäisches Patentamt

European Patent Office

Office européen des brevets

(19)

(11) Publication number: **0 047 035**
**B1**

(12) **EUROPEAN PATENT SPECIFICATION**

(45) Date of publication of patent specification: **18.12.85**

(51) Int. Cl.⁴: **H 01 L 27/15,** H 01 L 33/00, H 01 L 31/14

(21) Application number: **81200938.9**

(22) Date of filing: **24.08.81**

(54) **Light emitting semiconductor structure.**

(30) Priority: **29.08.80 NL 8004912**

(43) Date of publication of application:
**10.03.82 Bulletin 82/10**

(45) Publication of the grant of the patent:
**18.12.85 Bulletin 85/51**

(84) Designated Contracting States:
**DE FR GB NL**

(56) References cited:
**DE-A-2 420 517**
**DE-A-2 714 682**
**FR-A-2 335 056**
**US-A-3 894 295**
**US-A-3 978 507**
**US-A-4 127 792**
**US-A-4 176 367**

(73) Proprietor: **BOGEY B.V.**
**Maasschriksel 13 P.O. Box 1006**
**NL-5900 BA Venlo (NL)**

(72) Inventor: **Beaujean, Joseph Marie Elise**
**Maaskade 113**
**NL-5911 EZ Venlo (NL)**

(74) Representative: **van der Beek, George Frans**
**et al**
**Nederlandsch Octrooibureau Johan de Wittlaan**
**15 P.O. Box 29720**
**NL-2502 LS 's-Gravenhage (NL)**

EP 0 047 035 B1

Courier Press, Leamington Spa, England.

## Description

The invention relates to a light emitting semiconductor structure consisting of a thin active layer, which layer at one side passed into a doped cathode layer in direct contact with a first cathode electrode, and which layer at the other side passes into a oppositely doped anode layer, in direct contact with a second anode electrode, which electrodes during operation of the structure are connected to a current source to generate a current of carriers through the light emitting semi-conductor structure and which anode layer comprises a permeable barrier for said carriers, the permeability of said barrier being dependent on the voltage applied to a third electrode.

From DE—A—2,714,682 and US—A—4,127,792 light emitting semi-conductor structures are known in which the current flowing from the upper side to the lower side of the semiconductor structure (i.e. a high forward current from the anode electrode to the cathode electrode) is controlled by the spread of a depletion layer resulting from the reverse voltage applied to a gate electrode disposed in ohmic contact with an annular p+ type semi-conductor region. A change of spread of the depletion layer disposed around the pn gate junction varies the cross-sectional area of the current passageway and so controls the forward current. By this means the radiant output from the luminescent element can be adjusted. The p+ type control layer does not need to take the form of an annular but can also take the form of a buried strip traversing the semiconductor layer of the substrate (see Figure 5c in US—A—4,127,792). This document indicates moreover that the cross sectional profile of the current passagway is not limited to a circle and that it may have any desired profile as long as the edge of the depletion layer can be spread by a cutoff voltage for the controlled luminescent element sufficiently to block the passageway. In the structure disclosed by US—A—4,127,792 the electrodes connected to the gate junctions are positioned at the sides of the semiconductor structure.

However, DE—A—2,714,682 discloses (see Figure 7A—7B) a light emitting semiconductor structure in which the gate control regions are adjacent to the cathode side of the device (see also page 31 paragraphs 3—4, page 32 paragraphs 1—2). The gate electrodes and cathode electrodes are thus in ohmic contact with semiconductor regions of opposite conductivity but on the same surface. Moreover, the gate electrodes can as well be provided on the upper (anode) surface of the device.

Further embodiments in which such canal zones with variable cross sectional areas are provided are disclosed in Figures 8, 9 (DE—A—2,714,682). In Figure 8, Schottky contacts are provided to control the direct current flow meanwhile in Figure 9, a groove surrounds the luminescent junction in the cathode layer such that a reverse voltage applied to a gate layer pinches off the direct current passageway between anode and cathode under the bottom of the groove.

Both the US—A—4,127,792 and the DE—A—2,714,682 have the disadvantage of a circumstantial fabrication method.

An object of the invention is now to at least considerably eliminate the disadvantages of said above mentioned known configurations and to ease and facilitate fabrication and manufacture of light emitting semi-conductor structures.

According to the invention the light emitting semi-conductor structure described in the heading is characterized in that the barrier is embodied as an insulating layer inside the oppositely doped layer having an opening positioned close underneath that part of the surface of said oppositely doped layer where the third electrode is positioned, such that when a control voltage is applied to said third electrode, the carrier direct current between the anode and cathode electrode through the opening in said barrier can be more or less pinched off as a result of the spread of the depletion layer with respect to said opening.

The physical process determining the passage of carriers through said barrier may be based on the withdrawal or injection of carriers into the barrier area for instance by means of field effects.

The semiconductor layers on both sides of the light emitting layer may be further structured. That implies that it is possible to vary (partly) the crystallographic structure of the layers, that parts of said layers may be differently doped or that parts of said layers are made from different semiconductor materials.

In the following the configuration of the semiconductor structure according to the invention will be discussed in detail referring to preferred embodiments. Thereby the functioning of the invention will be explained without limiting the scope of the invention to the theoretical explanation of said operation.

A preferred embodiment of the semiconductor structure according to the invention is characterized in that the third electrode is positioned on the outside of said anode layer and positioned at some distance of said electrode.

It is remarked that US—A—3,978,507 discloses how a MIS structure with a third electrode close to the anode electrode can influence the injected carriers. However, the light emitting semiconductor structure to which said MIS structure is applied does not contain an insulating layer inside the oppositely doped layer.

A further preferred embodiment of the semiconductor structure according to the invention is characterized in that the third electrode is positioned on the outside of the anode layer at some distance of the second anode electrode and the third electrode forms a Schottky-contact with said anode layer.

In some applications a number of light emitting diode are used, especially semiconductor laser diodes, for instance in a multichannel optical amplifier or optical detection array. Preferable in such applications the second electrode comprises an elongated electrode segment and elongated mutually parallel electrode fingers extending preferably approximately prependicular to said elongated electrode segment, whereby the third electrode comprises a number of elongated electrode strips extending between the electrode fingers of said second electrode, and said insulating barrier comprises a number of barrier segments positioned underneath the electrode fingers of said second electrode, whereby the intermediate openings between said barrier segments are positioned underneath the electrode strips of said third electrode.

In a further development of said embodiment it is possible to control all the laserdiodes, which are in this way constructed and integrated together, each separately. To that end each of said electrode strips of the third electrode is connected to a separate control voltage source.

When a configuration is used in which the Schottky-effect is utilized, as is already mentioned above, then the third electrode may be embodied as a series of parallel extending electrode strips, whereby the dimensions of the intermediate openings are fulfilling the above mentioned dimensional requirements.

Also in this case it is possible to control each of the laser-diode elements separately by connecting each of the electrode strips of the third electrode to a separate control voltage source.

Until now embodiments of the invention are discussed in which within the structure according to the invention the functions of light emittor and the control element controlling said light emittor are combined into a compact integrated circuit. Within the structure according to the invention however also a light detecting function may be realized or said function is already present in the structure, namely as the semiconductor material adjoining the control electrode is totally or partly structured such, that this area is photoconductive. Such a light detection function within the semiconductor structure according to the invention may be utilized directly to control the light emission. According to a preferred embodiment therefore the semiconductor structure adjoining the third electrode is totally or partly made photoconductive. With such a semi conductor-structure it is possible to amplify incoming light impulses into stronger outgoing light impulses.

To further explain the invention in the following a number of embodiments of the invention will be described in details, whereby it is remarked that the invention is not restricted to said embodiments.

Fig. 1 shows a first embodiment of the invention.

Fig. 2 shows a second embodiment of the invention.

Fig. 3 shows a third embodiment of the invention.

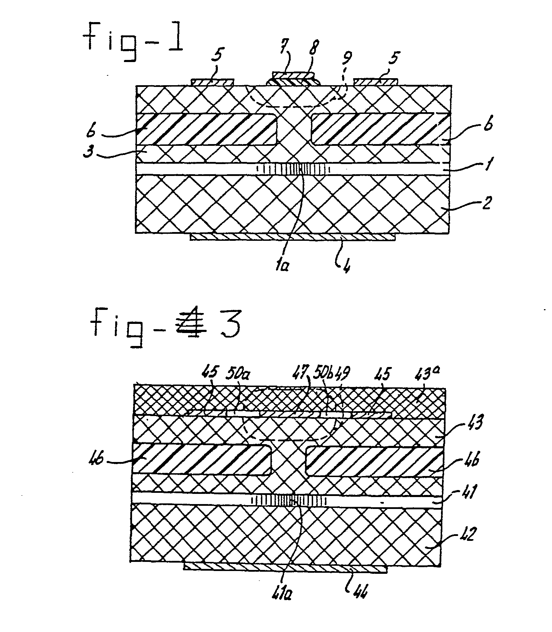

Fig. 1 shows a first embodiment of the invention. The active layer passes at the underside in a doped layer 2, to which the electrode 4 is attached. The layer 2, which is illustrated as a uniform layer in the figure, may eventually be further structurized. The active layer 1 passes at the upper side into a further oppositely doped layer 3, at the upper surface of which an electrode 5 is attached. Also said layer 3 may be further structurized, although this is not illustrated in the figure. The parts 1, 2, 3, 4 and 5 form a known light emitting semiconductor diode structure.

An insulating barrier with at least one opening is positioned into the oppositely doped upper layer 3. Above said opening a third electrode 7 is positioned onto the surface of the layer 3, electrically separated from the semiconductor material of the layer 3, for instance by means of an insulating layer 8.

When a current course is connected to the electrodes 4 and 5 such, that the diode structure is connected in the conducting direction, then an electron current can flow for instance from electrode 5 through the opening in the barrier 6 and through layers 3, 1 and 2 to the electrode 4. If said electron current is powerful enough then the recombination in the active layer 1, resulting into the transmission of electromagnetic radiation, will be stronger than the absorption of electromagnetic radiation in said layer, so that light will be emitted. If the front and the rear side of the structure as viewed in Fig. 1 have mirror surfaces, of which at least one surface is partly pervious for the generated light, then a laser function can be realized. According to the invention it is now possible to control the electron current through the diode structure by connecting the electrode 7 to a control voltage source. By connecting said electrode to a control voltage source a field is generated in the upper layer 3 as is indicated with the dotted line 9 in Fig. 1. If the voltage of the electrode 7 is high enough then said field can extend sufficiently to close the opening in the barrier completely, so that the electron current is cut off and no light will be emitted. At smaller values of the control voltage the electron current can be controlled such that the intensity of the emitted light varies dependent on the control voltage. The part of the active layer in which light will be generated is in the figure indicated as the shaded part 1a of said layer.

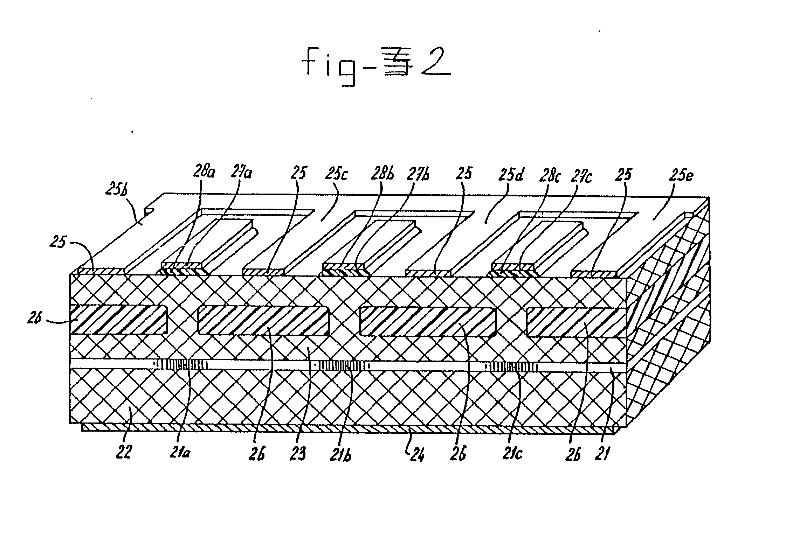

Fig. 2 illustrates a further embodiment of the semiconductor structure according to the invention, which is a further development of the basic configuration of Fig. 1. The diode structure in general comprises also in this case the active layer 21, bounded at the underside by the further or not structured doped layer 22 having the electrode 24 and at the upper side bounded by the further or not structured oppositely doped semiconductor layer 23 having the electrode 25. An insulating barrier 26 with a number of openings is positioned inside the upper layer 23. Above said openings third electrodes 27a, 27b and 27c are positioned separated from the semiconductor material of the layer 23 by means of the insulating layers 28a, 28b and 28c respectively. As will be clear in this way a number of potentially light emitting areas in the active layer are created, indicated as the areas 21a, 21b and 21c.

As is indicated in Fig. 2 the electrode 25 comprises an elongated electrode segment 25a to which mutually parallel and preferably perpendicular to the electrode segment 25a extending electrode ringers 25b, 25c, 25d and 25e are connected. Between the fingers 25b, 25c, 25d and 25e the electrodes 27a, 27b and 27c are positioned. In this embodiment all the electrodes 27a, 27b, 27c could be connected to the same control voltage source such that the intensity of the light emitted from the areas 21a, 21b, 21c will vary in the same way, but it is also possible to connect the electrodes 27a, 27b, 27c to separate control voltage sources such that the light emitting areas 21a, 21b and 21c can be controlled independently.

In a similar way it is possible to create a multiple configuration starting from the basic configuration illustrated in Fig. 2. Also without a detailed illustration it will be clear that in that case the third electrode 17 positioned into the upper layer 13 has a number of openings, each corresponding with a separate potentially light emitting area in the active layer 11.

In the Figs. 1 and 2 an insulating layer 8, 28 is present between the layer 3, 23 and the third electrode 7, 27. However, it is also possible to attach the electrode 7, 27 into the layer 3, 23 with a Schottky-junction, in which case the insulating layer 8, 28 is eliminated. The forming of a Schottky-zone underneath the electrode 7, 27 results into the creation of an area through which no current flows and dependent on the control voltage applied to the electrode 7, 27 the potential field from said Schottky-zone can completely close the opening in the barrier 6, 26 or can allow a carrier current of minor or larger value.

When the electrode 7, 27 is embodied with a Schottky-junction there is no objection to embody also the electrode 5, 25 with a Schottky junction, which as will be clear, has technical advantages in the fabrication process.

In all the discussed embodiments of the invention it is furthermore possible to realize very easily a light detector function or such a function is already present in a natural way, namely in the case that the semiconductor material adjoining the control electrode (7, 17, 27) is completely or partly structured such that said area is photoconductive. Furthermore such a light detection function within the semiconductor structure according to the invention may be utilized to control directly the light emission.

Fig. 3 illustrates a configuration which is similar to the configuration of Fig. 1, however with the first difference that the electrode 47 of the layer 43 forms a Schottky-junction which possibility however is already discussed above. In this case it is possible without objection, as is already stated, to embody also the electrode 45 onto the layer 43 with a Schottky-junction. Furthermore the upper semiconductor layer 43 is extended above the second electrode 45 and the third electrode 45 in the section 43a, whereby in this embodiment an interruption (50, 50b) of said extended layer is created between said electrodes. Said interruption may be created into the structure in that locally material is used of which the absorption coefficient for incoming light is smaller than the absorption coeficient of the surrounding semiconductor material. The further parts 41, 41a, 42, 44 and 46 are embodied similar to the corresponding parts 1, 1a, 2, 4 and 6 in Fig. 1. If in this case light is inciding perpendicular to the plan of the drawing, then said light will partly be absorbed in the semiconductor structure around the control electrode 47. Thereby the indicated interruption (50a, 50b) of the semiconductor layer will function as light channel conducting the light over an extended area into the semiconductor layer around the control electrode. If said absorbing area is photoconductive, then the generation of a current inhibiting field around the control electrode will be prevented because free carriers will be generated as a result of the inciding light, so that the section 41 of the layer 41 will show a strong light emission.

In said configuration also very weak incoming light impulses, which are not strong enough themselves to sufficiently break down the Schottky zone by generation of free carriers, can be amplified. To that end the electrode 47 is connected to the control voltage source through a resistor having great resistance value. If there is no light inciding onto the electrode 47 then the Schottky zone is developed and there is no current flowing through the structure, so that there is also no light emission. When a weak light impulse is inciding onto the electrode 47 then in the Schottky zone a few free carriers will be generated resulting into a very small current flowing from the control voltage source through the above mentioned resistor. Said small current however results into changing of the voltage potential onto the electrode 47 such, that the current inhibiting zone is decreased so that a stronger current can flow through the structure and a stronger light impulse will be emitted.

It is remarked that instead of a light sensitive Schottky junction also a light sensitive PN-junction may be utilized. In Fig. 1 it is for instance possible to insert a further doped semi-conductor layer underneath the electrode 5, forming a PN-junction with the layer 3. If said PN-junction and the electrode are sufficiently light transmitting, then said PN-junction, which is connected in the reverse direction, will be conducting when light is inciding, so that only if indeed light is inciding onto said PN-junction a current can flow through the structure resulting into light emission.

Although in the above illustrated and discussed embodiments rectangular and parallel electrodes are indicated it will be clear that also embodiments with radially shaped electrodes or electrodes having a different configuration can be utilized.

The semiconductor structure according to the invention, especially the embodiment illustrated in Fig. 3, can be applied with advantage in optical cables for transmission of information. To compensate the attenuation in such cables semiconductor structures according to the invention can be installed at regular distances in such an optical cable functioning as optical amplifier.

Also the semiconductor structure according to the invention can be applied with advantage for registrating and reading optical information onto respectively from a suitable information carrier.

## Claims

1. Light emitting semiconductor structure consisting of a thin active layer, which layer at one side passes into a doped cathode layer in direct contact with a first cathode electrode, and which layer at the other side passes into an oppositely doped anode layer, in direct contact with a second anode electrode, which electrodes during operation of the structure are connected to a current source to generate a current of carriers through the light emitting semiconductor structure and which anode layer comprises a permeable barrier for said carriers, the permeability of said barrier being dependent on the voltage applied to a third electrode, characterized in that the barrier is embodied as an insulating layer (6,26,46) inside the oppositely doped layer having an opening positioned close underneath that part of the surface of said oppositely doped layer where the third electrode (7,27,47) is positioned, such that when a control voltage is applied to said third electrode, the carrier direct current between the anode and cathode electrode through the opening in said barrier can be more or less pinched off as a result of the spread of the depletion layer with respect to said opening.

2. Light emitting semiconductor structure according to claim 1, characterized in that the third electrode is positioned on the outside of the anode layer at some distance of the second anode electrode and the third electrode forms a Schottky-contact with said anode layer.

3. Light emitting semiconductor structure according to claim 1, characterized in that the third electrode is positioned on the outside of the anode layer, electrically insulated from the semiconductor material of said anode layer and positioned at some distance of said second anode electrode.

4. Semiconductor structure according to one of the preceding claims, characterized in that the second anode electrode comprises an elongated electrode segment (25a) and elongated mutually parallel electrode fingers (25b, 25c, 25d, 25e) extending preferably approximately perpendicular to said elongated electrode segment, whereby the third electrode (27) comprises a number of elongated electrode strips (27a, 27b, 27c) extending between the electrode fingers of said second electrode and said insulating barrier (28) comprises a number of barrier segments (28a, 28b, 28c) positioned underneath the electrode fingers of said second electrode, whereby intermediate openings between said barrier segments (26) are positioned underneath the electrode strips of said third electrode.

5. Semiconductor structure according to claim 4, characterized in that each of the electrode strips of the third electrode can be connected to a separate control voltage source.

6. Semiconductor structure according to one of the preceding claims, characterized in that in said semiconductor structure a partly or completely photosensitive area is created adjoining the third electrode.

7. Semiconductor structure according to claim 6 having a Schottky-zone, characterized in that the Schottky-zone is made photosensitive into the opening or openings (50a, 50b) of the third electrode respectively underneath said third electrode.

8. Semiconductor structure according to claim 7, characterized in that the structure of the anode layer comprises a section (43a) extending above the second and third electrode, whereby the structure between said second and third electrode at least in the proximity of the third electrode has an absorption coefficient for inciding light which is smaller than the absorption coefficient of the surrounding semiconductor material.

9. Semiconductor structure according to claim 8, characterized in that the structure between the second and third electrode at least adjoining the third electrode has openings (50a, 50b) functioning as light channel.

10. Optical cable comprising a semiconductor structure according to one of the preceding claims.

11. System for detecting optically readible registered information comprising a semiconductor structure according to one of the preceding claims 1—9.

12. System for registration of optical information onto a suitable registration medium comprising a semi-conductor structure according to one of the preceding claims 1—9.

## Patentansprüche

1. Licht-emittierende Halbleiter-Anordnung, bestehend aus einer dünnen aktiven Schicht, die auf einer Seite in direktem Kontakt mit einer ersten Kathoden-Elektrode in eine dotierte Kathodenschicht übergeht und die auf der anderen Seite in direktem Kontakt mit einer zweiten Anoden-Elektrode in eine gegenüberliegende dotierte Anodenschicht übergeht, wobei Anode und Kathode im Betrieb an eine Stromquelle angeschlossen sind, um einen Trägerstrom durch die Licht-emittierende Halbleiter-Anordnung zu erzeugen, und wobei die Anodenschicht eine Träger-durchlässige Schranke umfasst, deren Durchlässigkeit von der an eine dritte Elektrode angelegten Spannung abhängt, dadurch gekennzeichnet, daß die Schranke als eine Isolierschicht (6, 26, 46) ausgebildet ist, die innerhalb der gegenüberliegenden dotierten Schicht angeordnet ist und eine Öffnung aufweist, die dicht unterhalb jenes Oberflächenbereiches der gegenüberliegenden dotierten Schicht liegt, an dem die dritte Elektrode angeordnet ist, derart, daß - wenn an die dritte Elektrode eine Steuerspannung angelegt ist - der durch die Öffnung in der Schranke fließende Träger-Gleichstrom zwischen der Anode und der Kathode entsprechend der Ausbreitung der Sperrschicht in Bezug auf die Öffnung mehr oder weniger eingeschnürt ist.

2. Licht-emittierende Halbleiter-Anordnung nach Anspruch 1, dadurch gekennzeichnet, daß die dritte Elektrode auf der Aussenseite der Anodenschicht in einigem Abstand von der zweiten Anoden-Elektrode angeordnet ist, und daß die dritte Elektrode mit der Anodenschicht einen Schlottky-Kontakt bildet.

3. Licht-emittierende Halbleiter-Anordnung nach Anspruch 1, dadurch gekennzeichnet, daß die dritte Elektrode von dem Halbleitermaterial der Anodenschicht elektrisch isoliert auf der Aussenseite der Anodenschicht und in einigem Abstand von der zweiten Anoden-Elektrode angeordnet ist.

4. Halbleiter-Anordnung nach einem der vorhergehenden Ansprüche, dadurch gekennzeichnet, daß die zweite Anoden-Elektrode aus einem länglichen Elektrodensegment (25a) mit zueinander parallelen länglichen Elektrodenfingern (25b, 25c, 25d, 25e) besteht, die sich vorzugsweise etwa senkrecht zu dem länglichen Elektrodensegment erstrecken, wobei die dritte Elektrode (27) aus einer Anzahl von länglichen Elektrodenstreifen (27a, 27b, 27c) besteht, die sich zwischen den Elektrodenfingern der zweiten Anoden Elektrode erstrecken, und daß die isolierende Schranke (28) aus einer Anzahl von Schrankensegmenten (28a, 28b, 28c) besteht, die unterhalb der Elektrodenfinger der zweiten Anoden-Elektrode angeordnet sind, wobei zwischen den Schrankensegmenten (26) unterhalb der Elektrodenstreifen der dritten Elektrode Zwischenöffnungen angeordnet sind.

5. Halbleiter-Anordnung nach Anspruch 4, dadurch gekennzeichnet, daß jeder Elektrodenstreifen der dritten Elektrode an eine separate Steuerspannungsquelle anschließbar ist.

6. Halbleiter-Anordnung nach einem der vorhergehenden Ansprüche, dadurch gekennzeichnet, daß in der Halbleiter-Anordnung ein teilweise oder vollständig lichtempfindlicher Bereich erzeugt ist, der der dritten Elektrode benachbart ist.

7. Halbleiter-Anordnung nach Anspruch 6 mit einer Schlottky-Zone, dadurch gekennzeichnet, daß die Schlottky-Zone in der oder den Öffnungen (50a, 50b) der dritten Elektrode beziehungsweise unterhalb der dritten Elektrode lichtempfindlich ausgeführt ist.

8. Halbleiter-Anordnung nach Anspruch 7, dadurch gekennzeichnet, daß der Aufbau der Anoden schicht einen Abschnitt (43a) umfasst, der sich oberhalb der zweiten und dritten Elektrode erstreckt, wobei der Aufbau zwischen der zweiten und dritten Elektrode zumindest in der Nähe der dritten Elektrode einen Absorptions-Koeffizienten für einfallendes Licht hat, der kleiner ist als der Absorptions-Koeffizient des umgebenden Halbleitermaterials.

9. Halbleiter-Anordnung nach Anspruch 8, dadurch gekennzeichnet, daß der Aufbau zwischen der zweiten und dritten Elektrode zumindest neben der dritten Elektrode Öffnungen (50a, 50b) aufweist, die als Lichtkanal wirken.

10. Optisches Kabel mit einer Halbleiter-Anordnung gemäß einem der vorhergehenden Ansprüche.

11. System zum Erfassen optisch lesbarer registrierter Informationen mit einer Halbleiter-Anordnung nach einem der vorhergehenden Ansprüche 1—9.

12. System zum Registrieren optischer Informationen auf einem geeigneten Registriermittel mit einer Halbleiter-Anordnung nach einem der vorhergehenden Ansprüche 1—9.


**Revendications**

1. Structure semiconductrice luminescente comprenant une couche mince active qui passe d'un côté dans une couche cathodique dopée en contact direct avec une première électrode cathodique, et d'un autre côté dans une couche anodique dopée de façon opposée en contact direct avec une seconde électrode anodique, lesquelles électrodes, pendant le fonctionnement de la structure, sont reliées à une source de courant pour produire un courant de porteurs à travers la structure semiconductrice luminescente, et dont la couche anodique comprend une barrière perméable à ces porteurs, la perméabilité de cette barrière dépendant de la tension appliquée à une troisième électrode, caractérisée en ce que la barrière est réalisée selon une couche isolante (6, 26, 46) à l'intérieur de la couche dopée en sens opposé, ayant une ouverture positionnée juste endessous de la partie de la surface de la couche dopée en sens opposé où la troisième électrode (7, 27, 47) est positionnée, si bien que, quand une tension de commande est appliquée à la troisième électrode, le courant direct de porteurs allant de l'anode à la cathode à tavers l'ouverture de la barrière peut être plus ou moins pincé suivant l'étendue de la couche de déplétion par rapport à cette ouverture.

2. Structure semiconductrice luminescente conforme à la revendication 1, caractérisée en ce que la troisième électrode est positionnée à l'extérieur de la couche anodique, à quelque distance de la seconde électrode anodique, et en ce que la troisième électrode forme un contact de SCHOTTKY avec la couche anodique.

3. Structure semiconductrice luminescente conforme à la revendication 1, caractérisée en ce que la troisième électrode est positionnée à l'extérieur de la couche anodique, électriquement isolée du matériau semiconducteur de cette couche anodique, et disposée à quelque distance de la seconde électrode anodique.

4. Structure semiconductrice conforme à l'une quelconque des revendications précédentes caractérisée en ce que la seconde électrode anodique comprend un segment d'électrode allongé (25a) et des doigts d'électrode allongés mutuellement parallèles (25b, 25c, 25d, 25e) s'étendant de préférence approximativement perpendiculaires au segment d'électrode, en ce que la troisième électrode (27) comprend plusieurs bandes d'électrodes allongées (27a, 27b, 27c) s'étendant entre les doigts d'électrode de la seconde électrode et en ce que la barrière isolante (28) comprend plusieurs segments de barrière (28a, 28b, 28c) disposés sous les doigts d'électrode de la seconde électrode de sorte que des ouvertures intermédiaires entre les segments de barrière (26) soient positionnées sous les bandes d'électrode de la troisiéme électrode.

5. Structure semiconductrice conforme à la revendication 4, caractérisée en ce que chacune des bandes d'électrode de la troisième électrode peut être reliée à une source séparée de tension de commande.

6. Structure semiconductrice conforme à l'une des revendications précédentes, caractérisée en ce que, dans cette structure, une plage totalement ou partiellement photosensible est créée, de façon contigüe à la troisième électrode.

7. Structure semiconductrice conforme à la revendication 6, possédant une zone de SCHOTTKY, caractérisée en ce que cette zone de SCHOTTKY est rendue photosensible dans l'ouverture ou les ouvertures (50a, 50b) de la troisième électrode, respectivement, en-dessous de cette troisième électrode.

8. Structure semiconductrice conforme à la revendication 7, caractérisée en ce que la structure de la couche anodique comprend une section (43a) s'étendant au-dessus de la seconde et de la troisième électrodes, de sorte que la structure entre la seconde et la troisième électrode, au moins à proximité de la troisième électrode, a un coefficient d'absorption de la lumière incidente inférieur à celui du matériau semiconducteur environnant.

9. Structure semiconductrice conforme à la revendication 8, caractérisée en ce que la structure entre la seconde et la troisième électrode possède des ouvertures (50a, 50b) fonctionnant en canal de lumière, au moins à proximité de la troisième électrode.

10. Câble optique comprenant une structure semiconductrice conforme à l'une des revendications précédentes.

11. Système de détection d'informations enregistrées optiquement lisibles comprenant une structure semiconductrice conforme à l'une des revendications 1 à 9.

12. Système d'enregistrement d'informations optiques sur un moyen d'enregistrement approprié comprenant une structure semiconductrice conforme à l'une des revendications 1 à 9.

Fig-1

Fig-#3

Fig-2